# EUROPEAN PATENT APPLICATION

(11) **EP 2 439 562 A1**
(43) Date of publication of application: **11.04.2012**
(21) Application number: 10196053.2
(22) Date of filing: 20.12.2010
(51) Int. Cl.: G01W 1/16, F03D 11/00, G01R 15/24, G01R 29/08, G01R 33/032

(54) **Lightning detection system**

(30) Priority: 08.10.2010 EP 10187018
(71) Applicant: PHOENIX CONTACT GmbH & Co. KG, 32825 Blomberg (DE); North Sensor A/S, 8520 Lystrup (DK)
(72) Inventor: Bjorn, Lars Norgaard, 8410 Ronde (DE); Wetter, Martin, 32760 Detmold (DE)
(74) Representative: Michalski Hüttermann & Partner

(57) **Abstract**

The invention refers to lightning detection system comprising a Faraday rotator (13, 31, 113) adapted for being arranged on or at a conductor (5) for receiving a lightning stroke and for transmitting a lightning induced current, the Faraday rotator (13, 31, 113) further being adapted for being influenced by the magnetic field which is induced by said lightning induced current, a light source (1) adapted for emitting light into the Faraday rotator (13, 31, 113), a light sensor (9)adapted for sensing the light which is transmitted through the Faraday rotator (13, 31, 113), and an analyzer (23) adapted for receiving a signal generated by the light sensor (9) and for outputting a lightning induced current signal, wherein the lightning induced current signal indicates at least one parameter of the lightning induced current, and the light source (1) comprises at least two different optical wavelengths. In this way, a lightning detection system can be achieved which is less prone to vibration interferences.

## Description

The present invention refers to a lightning detection system, especially to a lightning detection system using a Faraday rotator which is adapted for use in a wind turbine blade system.

Lightning strokes into wind turbines typically strike the blade system. In this way, the respective blade suffering the stroke can be damaged. For this reason, it is necessary to monitor whether a blade has suffered a lightning stroke. Further, since manufacturers of wind turbines typically guarantee a certain resisting power of their wind turbines against lightning strokes (e.g. "resistive up to a predefined current"), it is also desired to know the lightning induced current and/or electric charge.

In order to address above mentioned problems, fiber optic current sensor systems for detection lightning have been proposed. In US 7,468,505, which is incorporated by reference herein, a system for lightning detection is described which includes a conductor configured to receive a lightning stroke and transmit a lightning induced current. The system also includes a fiber optic current sensor configured to detect multiple lightning parameters from the lightning induced current and to modulate a beam of radiation in response thereto. The system further includes an electro-optic module configured to receive and convert the beam of radiation from the fiber optic current sensor to an electrical signal.

For localizing where a wind turbine has suffered a lightning stroke, all blades can be equipped with their own sensor or sensors. The sensors may comprise so called Faraday rotators which are optical devices that rotate the polarization of light due to the Faraday effect, which in turn is based on a magneto-optic effect. The plane of linearly polarized light is rotated when a magnetic field is applied parallel to the propagation direction. The angle of rotation is proportional to the magnetic flux density in the direction of propagation and the length of the path where the light and magnetic field interact. Further the angle of rotation depends on the material of the Faraday rotator and varies with the optical wavelength of the light transmitting the Faraday rotator.

However, such lightning detection system using a Faraday rotator for measuring the strength of the magnetic field of a lightning induced current and, in turn, the amount of the current, suffer from interferences by mechanical vibrations. Such vibrations cause noise when measuring the Faraday effect, making the measurement of the lightning induced current less reliable.

It is the object of the invention to provide a possibility to design a lightning detection system which is less prone to vibration interferences.

This object is solved by a lightning detection system comprising a Faraday rotator adapted for being arranged on or at a conductor for receiving a lightning stroke and for transmitting a lightning induced current, the Faraday rotator further being adapted for being influenced by the magnetic field which is induced by said lightning induced current, a light source adapted for emitting light into the Faraday rotator, a light sensor adapted for sensing the light which is transmitted through the Faraday rotator, and an analyzer adapted for receiving a signal generated by the light sensor and for outputting a lightning induced current signal, wherein the lightning induced current signal indicates at least one parameter of the lightning induced current, and the light source comprises at least two different optical wavelengths.

Thus, it is an essential idea of the invention to provide a lightning detection system which is equipped with a light source with at least two different optical wavelengths which allows for compensation of vibration induced interferences.

In general, the light source, the light sensor and the Faraday rotator can be combined in one single module. However, according to a preferred embodiment of the invention, the light source and the light sensor are arranged in an electro-optic module, and the Faraday rotator is optically coupled to the electro-optic module by an optical waveguide. In this way, the light source and the light sensor can be located at a location remote from the actual sensor, i.e. the Faraday rotator, which reduces the danger of damaging the light source and/or the light sensor by the lightning stroke.

The system can be used for a single conductor. According to a preferred embodiment of the invention, the system is used for a plurality of conductors, each conductor being equipped with at least one Faraday rotator. In this way, space-resolved lighting detection is made possible. Further, according to a preferred embodiment of the invention, each Faraday rotator is coupled to a separate electro-optic module. Moreover, according to a preferred embodiment of the invention, multiple electro-optic modules are connected to a single analyzer common to all modules.

Furthermore, it is preferred that the light source comprises two light source means, preferably two light emitting diodes, with different optical wavelengths and/or a white light source, preferably a white light emitting diode.

According to a preferred embodiment of the invention, a first polarizer is arranged between the light source and the Faraday rotator for polarizing the light emitted into the Faraday rotator. Preferably, the first polarizer is active for both optical wavelengths of the light source.

Further, it is preferred that the light sensor comprises one or two light sensor means, preferably one photodiode or two photodiodes.

In the latter case of two light sensor means, it is preferred that the light which is transmitted through the Faraday rotator is split off into a first beam and a second by a beam splitter, wherein the first beam is directed onto a first light sensor means and the second beam is directed onto a second light sensor means. Furthermore, it is preferred that between the beam splitter and the first photodiode a first color filter is arranged and between the beam splitter and the second photodiode a second color filter is arranged, the optical transmission of the first color filter and the second filter being different for at least one wavelength range. This allows for color-resolved beam detection.

According to a preferred embodiment of the invention, a second polarizer is arranged between the Faraday rotator and the light sensor for polarizing the light which is transmitted through the Faraday rotator. Preferably, the second polarizer is only active for one optical wavelength of the light source. If the first polarizer is active for both wavelengths and the second polarizer is only active for one wavelength, the following advantage can be achieved. The light with the optical wavelength which is influenced by both the first polarizer and the second polarizer contains both the actual signal due to the detected lighting stroke and a noise signal due to vibration and birefringence, i.e. a combined signal. Since the light with the other optical wavelength is only influenced by the first polarizer, this light only contains the noise signal due to vibration and birefringence. In this way, with the aid of the two optical wavelengths, the noise can be subtracted from the combined signal yielding the actual signal.

Furthermore, it is preferred that the polarization direction of the first polarizer is different from the polarization direction of the second polarizer. In this way, positive and negative currents and, thus, positive and negative turns can be detected, respectively. It is especially preferred that the angle between the polarization directions is 45°.

According to a preferred embodiment of the invention, the at least one parameter of the lightning induced current comprises electric current and/or electric charge.

Furthermore, according to a preferred embodiment of the invention, a first transceiver system with a first light source for emitting light of a first wavelength and a first light sensor for detection light of a second wavelength which is different from the first wavelength, and a second transceiver system with a second light source for emitting light of the second wavelength and a light sensor for detection of light of the first wavelength are provided on opposite sides of the Faraday rotator.

Preferably, both transceivers use wavelength-division multiplexing (WDM) for feeding light into a single optical waveguide and receiving light. The light coming from the one side is polarized by a first polarizer before being fed into the Faraday rotator, and by a second polarizer, when being fed out of the Faraday rotator. The light coming from the other side is first polarized by the second polarizer and then by the first polarizer.

The two different wavelengths are transported through the Faraday rotator at the same time, which means that both wavelength signals contain the actual signal due to the detected lighting stroke and a noise signal due to vibration and birefringence, i.e. a combined signal, respectively. The signals due to the lighting stroke are in opposite phase due to their different directions, but the noise signals are in phase. In this way, with the aid of the two optical wavelengths, the noise can be subtracted from the combined signal yielding the actual signal which can be used for estimating the current of the lightning stroke.

Finally, it is preferred that said lightning detection system is adapted for measuring at least one parameter of a lightning induced current in a wind turbine blade system.

In the following, the invention is explained in more detail with reference to the Figures.
- Fig. 1: schematically shows the general concept of current detection by a Faraday rotator;
- Fig. 2: schematically shows a Faraday rotator according to a preferred embodiment of the invention;
- Fig. 3: shows the general arrangement of a lightning detection system according to an embodiment of the invention;
- Figs. 4, 5, 6: show this concept of a lightning detection system according to different embodiments of the invention in more detail;
- Figs. 7, 8, 9: show Faraday rotator sensors according to different embodiments of the invention in more detail;
- Fig. 10: shows a closed Faraday rotator sensor attached to an electrical connector; and
- Fig. 11: shows the concept of a lightning detection system according to another embodiment of the invention in more detail.

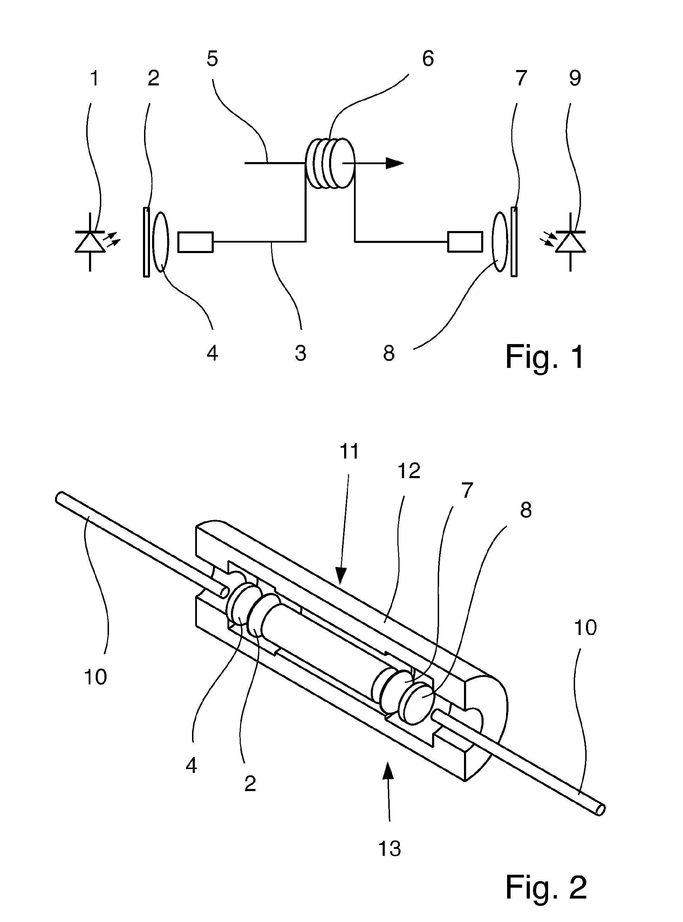

The general concept of current detection by a Faraday rotator can be understood from Fig. 1. Light which is emitted by a light source 1, i.e. a light emitting diode (LED), is polarized by a first polarizer 2 and then fed into an optical fiber 3 via a focusing lens 4. This optical fiber 3 is wound around a conductor 5 through which flows an electric current, the optical fiber forming a coil 6.

Since the magnetic field induced by the electric current surrounds the conductor 5 in the same manner as the coil 6, the magnetic field is parallel to the propagation direction of the light in the optical fiber 3. In this way, the plane of linearly polarized light is rotated according to the Faraday effect. Accordingly, the degree of rotation, led via a decoupling lens 8 and a second polarizer 7 onto a light sensor 9 for detection, is a measure for the magnetic field and, thus, for the electric current in the conductor 5. If the electric current is a lightning induced current in a blade of a wind turbine, this arrangement makes it possible to provide for a measure of the current in the blade due to the lightning stroke.

A Faraday rotator 13 according to a preferred embodiment of the invention can be designed as depicted in Fig. 2. According to this example, a polymer optical fiber (POF) cable 10 for guiding light is connected to a glass tube 11 via optical lenses 4, 8 from both sides. The glass tube 11 is held in a tube holder 12. On both sides of the tube holder 12, polarizing filters are arranged, i.e. a first polarizer 2 before the glass tube 11 and a second polarizer 7 after the glass tube. In this way, light fed into the POF cable 10 can be irradiated into the Faraday rotator 13, and the light transmitted through the Faraday rotator 13, showing a rotation of its polarization plane, can be detected at the other end of the POF cable 10.

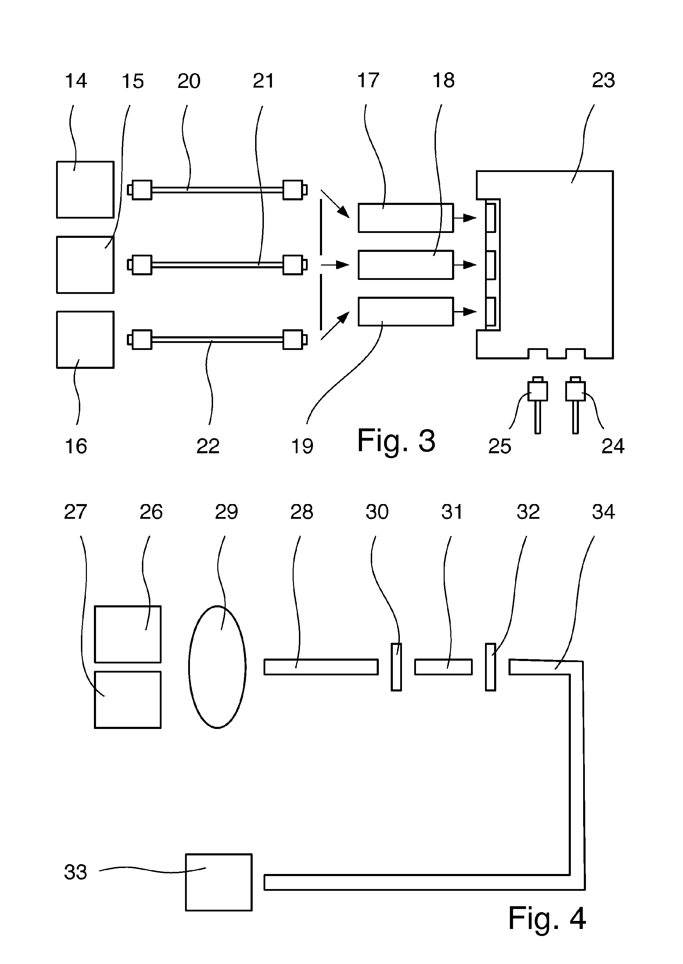

As shown in Fig. 3, preferably three sensors 14, 15, 16, e.g. such Faraday rotators 13 as explained above, are provided, i.e. one in each blade of a wind turbine. These sensors 14, 15, 16 are connected to electro-optic modules (O/E modules) 17, 18, 19 via fiber cables 20, 21, 22. In this way, each sensor 14, 15, 16 is equipped with its own O/E module 17, 18, 19, respectively. The O/E modules 17, 18, 19 are connected to a common lightning analyzer module 23 which analyzes the signals received by the O/E modules 17, 18, 19 and outputs data with respect to lightning parameters as current and/or charge via a data port 24. Electrical power is provided via an electrical connection 25 for power supply.

This concept is depicted in Figs. 4, 5, and 6 in more detail.

According to the embodiment shown in Fig. 4, two LEDs 26, 27 with different wavelengths, i.e. a first LED 26 emitting light of 650 nm wavelength and a second LED 27 emitting light of 470 nm wavelength, are used for feeding light into an optical waveguide 28 via lens 29. This light is polarized by a first polarizer 30, commercially available as "HN32", fed into the Faraday rotator 31, polarized by a second polarizer 32, commercially available as "HN38", and then fed to a a common photodiode 33 for detection via another optical waveguide 34.

The second polarizer 32 is only active for one optical wavelength of the light source, and the first polarizer 30 is active for both wavelengths. In this way, the light with the optical wavelength which is influenced by both the first polarizer 30 and the second polarizer 32 contains both the actual signal due to the detected lighting stroke and a noise signal due to vibration and birefringence, i.e. a combined signal. Since the light with the other optical wavelength is only influenced by the first polarizer 30, this light only contains the noise signal due to vibration and birefringence. In this way, with the aid of the two optical wavelengths, the noise can be subtracted from the combined signal yielding the actual signal which can be used for estimating the current of the lightning stroke.

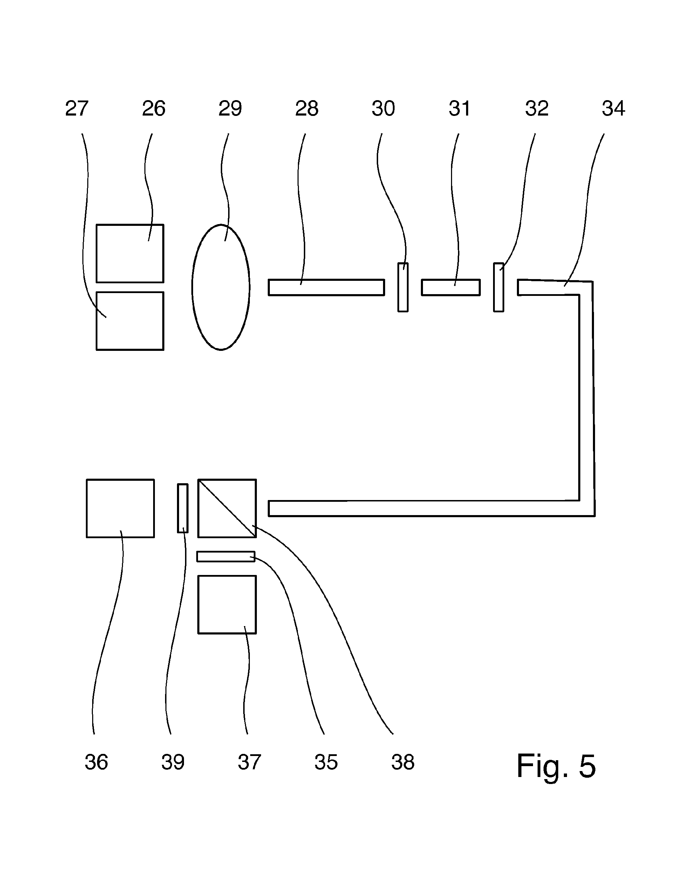

In contrast to this embodiment, the embodiment shown in Fig. 5 uses two separate photodiodes 36, 37 for detection. A beam splitter 38 is used to split up the beam into two beams which are perpendicular to each other and directed to one of the photodiodes 36, 37, respectively. In order to provide for color resolved detection, each photodiode 36, 37 is equipped with a color filter 34, 39, respectively, which only transmits light of the wavelength of the one LED 36 or the other LED 37.

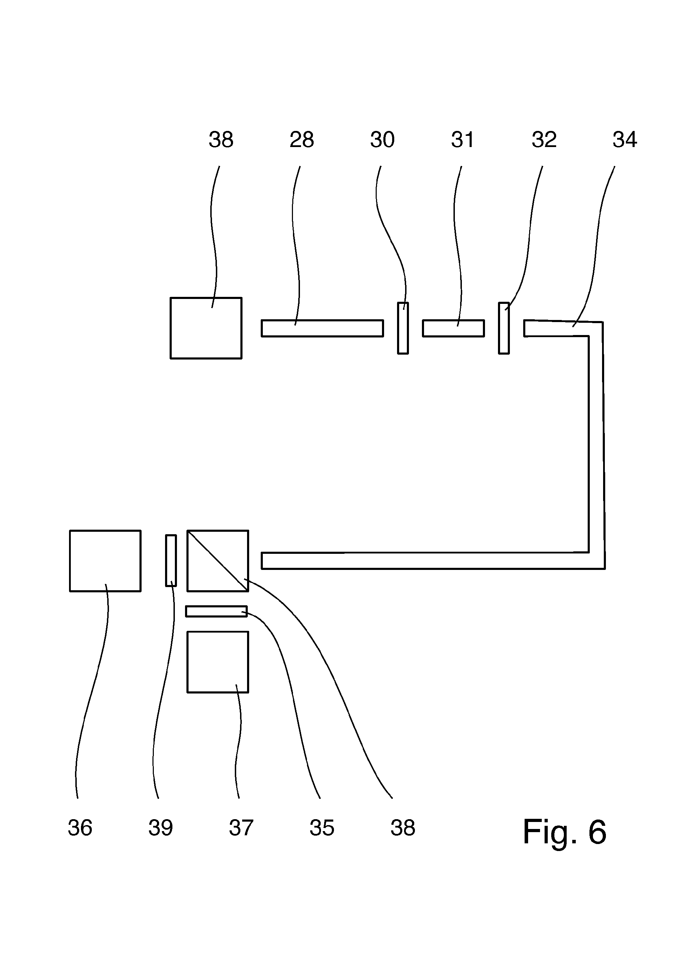

Further, in Fig. 6 an arrangement is shown which is identical to the arrangement of Fig. 5 except for the use of a white LED 38. Because of the color filters 34, 39, only a respective wavelength range of the white light which is transmitted by the color filters 34, 39 is used for detection.

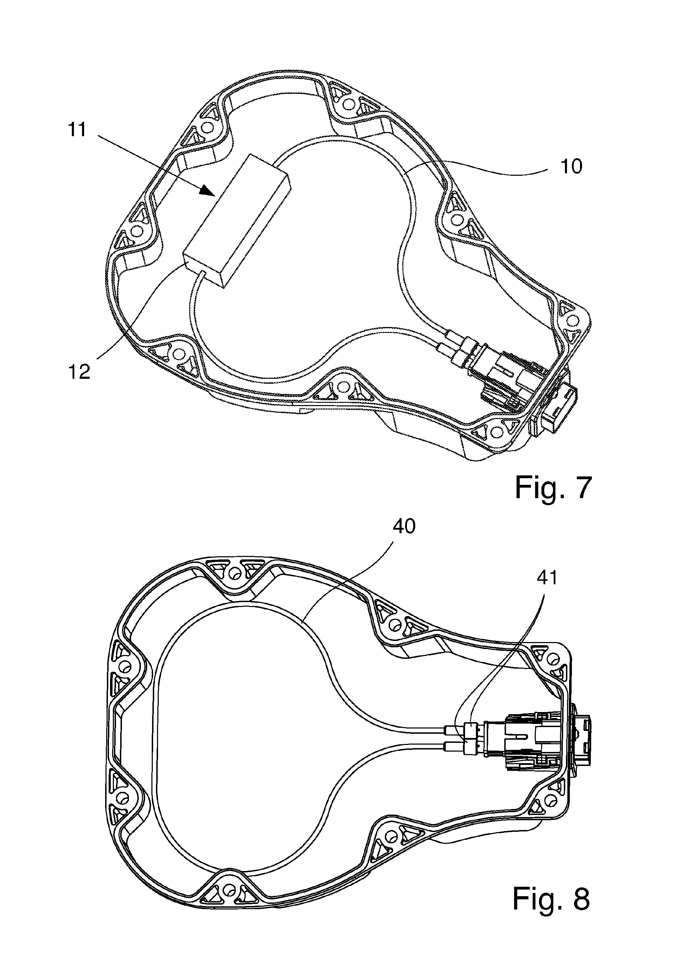

Preferred embodiments of sensors using a Faraday rotator are depicted in Figs. 7, 8, and 9.

According to Fig 7, a POF cable 10 is used which is connected to a glass tube 11 in a tube holder 12 as explained above with respect to Fig. 2.

Instead of a POF cable, a hard-clad silica optical fiber (HCS) cable 40 can be used. This is shown in Fig. 8. In this case, no glass tube is provided and the Faraday effect occurring in the HCS cable 40 itself is used. Polarizers are integrated into the connectors 41 of the HCS cable 40 and, thus, not shown separately.

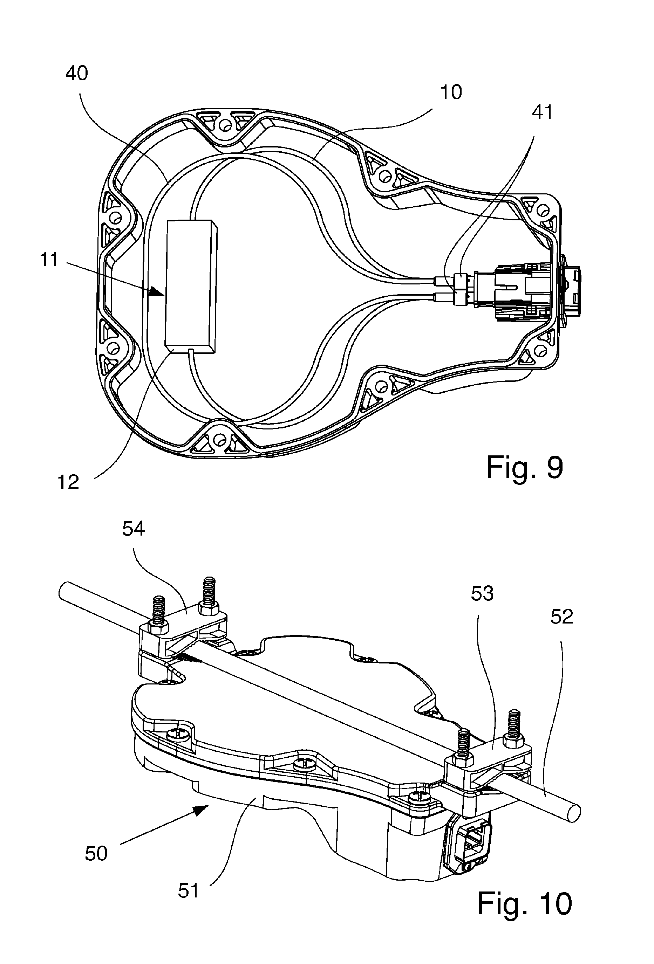

As shown in Fig 9, another embodiment of the invention applies a combination of the POF cable arrangement of Fig. 7 and the HCS cable arrangement of Fig. 8.

Further, Fig. 10 shows a Faraday rotator sensor 50 according to an embodiment depicted in one of Figs. 7 to 9 with its enclosure 51 fixed to a conductor 52 for transmitting a lightning induced current by fixtures 53, 54.

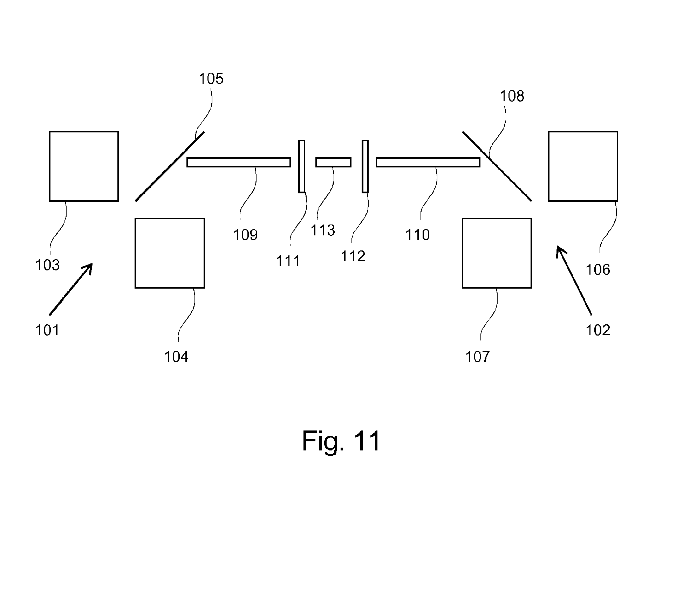

Finally, according to an embodiment shown in Fig. 11, two transceiver systems 101, 102 with different wavelength characteristics are provided, i.e. a first transmitter 103 for emitting light of 850 nm wavelength, a photodiode 104 for 1300 nm detection and a respective beam splitter 105, and a second transmitter 106 for emitting light of 1300 nm wavelength, a photodiode 107 for 850 nm detection and a respective beam splitter 108.

Both transceivers use wavelength-division multiplexing (WDM) for feeding light into a single optical waveguide 109, 110 and receiving light by the photodiodes 104, 107. The light coming from the left side in Fig. 11 is polarized by a first polarizer 111, commercially available as "APIR29-030", before being fed into the Faraday rotator 113, and by a second polarizer 112, commercially available as "APIR29-030", when being fed out of the Faraday rotator 113. The light coming from the right side is first polarized by the second polarizer 112 and then by the first polarizer 111.

The two different wavelengths are transported through the Faraday rotator 113 at the same time, which means that both wavelength signals contain the actual signal due to the detected lighting stroke and a noise signal due to vibration and birefringence, i.e. a combined signal, respectively. The signals due to the lighting stroke are in opposite phase due to their different directions, but the noise signals are in phase. In this way, with the aid of the two optical wavelengths, the noise can be subtracted from the combined signal yielding the actual signal which can be used for estimating the current of the lightning stroke.

## Claims

1. A lightning detection system comprising
a Faraday rotator (13, 31, 113) adapted for being arranged on or at a conductor (5) for receiving a lightning stroke and for transmitting a lightning induced current,
the Faraday rotator (13, 31, 113) further being adapted for being influenced by the magnetic field which is induced by said lightning induced current,
a light source (1) adapted for emitting light into the Faraday rotator (13, 31, 113),
a light sensor (9)adapted for sensing the light which is transmitted through the Faraday rotator (13, 31, 113), and
an analyzer (23) adapted for receiving a signal generated by the light sensor (9) and for outputting a lightning induced current signal, wherein
the lightning induced current signal indicates at least one parameter of the lightning induced current, and
the light source (1) comprises at least two different optical wavelengths.

2. The lightning detection system according to claim 1, wherein the light source (1) and the light sensor (9) are arranged in an electro-optic module (17, 18, 19), and the Faraday rotator (13, 31, 113) is optically coupled to the electro-optic module (17, 18, 19) by an optical waveguide (20, 21, 22).

3. The lightning detection system according to claim 2, comprising a plurality of Faraday rotators (13, 14, 15, 16), each Faraday rotator (13, 14, 15, 16) being adapted for being arranged at or on a separate conductor (5).

4. The lightning detection system according to claim 3, wherein each Faraday rotator (13, 14, 15, 16) is coupled to a separate electro-optic module (17, 18, 19).

5. The lightning detection system according to 4, wherein multiple electro-optic modules (17, 18, 19) are connected to a common analyzer (23).

6. The lightning detection system according to any of the preceding claims, wherein the light source (1) comprises two light source means, preferably light emitting diodes (26, 27), with different optical wavelengths and/or a white light source, preferably a white light emitting diode (38).

7. The lightning detection system according to any of the preceding claims, wherein a first polarizer (2, 30) is arranged between the light source (1) and the Faraday rotator (13, 31, 113) for polarizing the light emitted into the Faraday rotator (13, 31, 113).

8. The lightning detection system according to claim 7, wherein the first polarizer (2, 30) is active for both optical wavelengths of the light source (1).

9. The lightning detection system according to any of the preceding claims, wherein the light sensor (1) comprises one or two light sensor means, preferably one photodiode (33) or two photodiodes (36, 37).

10. The lightning detection system according to claim 9, wherein the light which is transmitted through the Faraday rotator (13, 31, 113) is split off into a first beam and a second by a beam splitter (38), wherein the first beam is directed onto a first light sensor means and the second beam is directed onto a second light sensor means.

11. The lightning detection system according to claim 10, wherein between the beam splitter (38) and the first light sensor means a first color filter (34) is arranged and between the beam splitter and the second light sensor means a second color filter (39) is arranged, the optical transmission of the first color filter (34) and the second filter (35) being different from each other for at least one wavelength range.

12. The lightning detection system according to any of the preceding claims, wherein a second polarizer (7, 32) is arranged between the Faraday rotator (13, 31, 113) and the light sensor (9) for polarizing the light which is transmitted through the Faraday rotator (13, 31, 113).

13. The lightning detection system according to claim 12, wherein the second polarizer (7, 32) is only active for one optical wavelength of the light source (1).

14. The lightning detection system according to any of the preceding claims, wherein the at least one parameter of the lightning induced current comprises electric current and/or electric charge.

15. The lightning detection system according to any of the preceding claims, wherein a first transceiver system (101) with a first light source (103) for emitting light of a first wavelength and a first light sensor (104) for detection light of a second wavelength which is different from the first wavelength, and a second transceiver system (102) with a second light source (106) for emitting light of the second wavelength and a light sensor (107) for detection of light of the first wavelength are provided on opposite sides of the Faraday rotator (113).
